# EUROPEAN PATENT SPECIFICATION

(11) **EP 0 910 799 B1**
(45) Date of publication and mention of the grant of the patent: **27.04.2005**
(21) Application number: 98903233.9
(22) Date of filing: 27.02.1998
(51) Int. Cl.: G01R 31/317, H03K 19/177, G06F 11/22

(54) **IDDQ TESTABLE PROGRAMMABLE LOGIC ARRAYS AND A METHOD FOR TESTING SUCH A CIRCUIT**
IDDQ-PRÜFBARE PROGRAMMIERBARE LOGIKMATRIZEN UND VERFAHREN ZUR PRÜFUNG SOLCHER SCHALTKREISE
MATRICES LOGIQUES PROGRAMMABLES DE TEST DE COURANT DE REPOS D'ALIMENTATION ELECTRIQUE (IDDQ) ET PROCEDE POUR TESTER CES CIRCUITS

(30) Priority: 21.03.1997 EP 97200847
(43) Date of publication of application: 28.04.1999
(73) Proprietor: Koninklijke Philips Electronics N.V., 5621 BA Eindhoven (NL)
(72) Inventor: SACHDEV, Manoj, NL-5656 AA Eindhoven (NL)
(74) Representative: van der Veer, Johannis Leendert
(86) International application number: PCT/IB1998/000248
(87) International publication number: WO 1998/043361

(56) References cited:
- US-A- 4 768 196
- US-A- 4 893 311
- US-A- 4 920 515
- US-A- 5 504 755

## Description

The invention relates to an integrated circuit comprising a dynamic CMOS Programmable Logic Array with an AND plane and an OR plane, and to a method for testing an integrated circuit comprising a dynamic CMOS Programmable Logic Array with an AND plane and an OR plane.

US-A-4,768,196 discloses built-in self-test programmable logic arrays that use a deterministic test pattern generator to generate test patterns such that each cross point in an AND-plane can be evaluated sequentially. Instead of only determining the probability of fault detection, in this scheme, the fault detection capability has been analyzed using both the stuck at fault and the contact fault model. It can be shown that all of these faults can be detected. Shorts between two adjacent lines can be detected by using NOR gates.

US-A-5,504,755 discloses a testable programmable logic array (PLA). A testable PLA includes a PLA comprising an AND plane and an OR plane comprising input lines, output lines, and product term lines which are grouped into at least two groups; a selector circuit for selecting one of the groups; an activation circuit for activating the selected group; a data generator for providing test data to execute a test for the PLA for the AND plane during a test operation mode, and for providing normal input data for the AND plane during a normal operation mode. The test data consisting of fixed data and variable data provided from the data generator corresponds to the distribution of devices formed at crosspoints between the product term lines of each of the selected groups and input lines.

US-A-4,893,311 discloses a CMOS implementation of a Built In Self Test Input Generator (BISTIG) for testing embedded PLA structures. The BISTIG tests for all stuck at faults, cross-point faults and bridging faults, by asserting exactly one input row and exactly one product term of the PLA under test at a time:

The Programmable Logic Array (PLA) is an important building block for VLSI circuits. It is commonly used in the design of instruction decoders of microprocessors, and combinational circuitry of finite state machines. The widespread use of the PLA is due to its simple architecture and availability of programs to automate the synthesis process. Dynamic PLAs are preferred compared to their static counterparts due to smaller area, low power dissipation and the ability to pipeline the processing for increased throughput.

In spite of their merits, PLAs are notorious for poor testability. Built In Self Test (BIST) schemes have been devised for functional testing of PLAs. However, these test schemes normally entail a large number of extra gates and test vectors. A second drawback is that implementation of these test schemes often heavily depends on the function implemented in the PLA, which leads to extra steps in the design process. A third drawback is that the known test schemes do not enable explicit testing for bridging faults between nodes. A bridging fault is formed by an unintended conductive bridge of low resistance. For circuits as specified in the preamble, bridging faults are particularly relevant in view of the large number of interconnections and densely packed lines. It has been found that, under the special circumstances of testing, a considerable amount of such defects are not detected by functional testing.

It is, inter alia, an object of the invention to provide an integrated circuit that enables explicit testing for bridging faults between nodes. The invention is defined by the independent claims. The dependent claims define advantageous embodiments.

In the invention, a bridging defect between lines of said pairs will give rise to an elevated power supply current. Monitoring the power supply current (which is known as IDDQ testing) then reveals the presence of the bridging defect. An advantage of this IDDQ testable circuit is that crosspoint transistor leakage can be detected as well. Furthermore, in order to implement the invention in a circuit as specified in the preamble, no function-dependent measures have to be taken. The latter means that the design process of the PLA is not burdened with extra design steps. Moreover, the invention can be implemented very efficiently in terms of IC area overhead.

A method for testing according to the invention will either replace or complement known functional test schemes. The quiescent power supply current can be measured by a Built-In Current Sensor (BISC) or by an off-chip current sensor connected to the IC during test. A method for testing according to the invention can be carried out very efficiently in terms of test time.

According to an aspect of the invention, the integrated circuit is characterized in that the bit lines and the product term lines are connected to respective outputs of logic gates, an input of each logic gate being connected to a first test control line, the arrangement being such that the logic gates enable driving the bit lines and product term lines to a switch off level of the crosspoint transistors connected thereto, under control of the first test control line. This enables switching off the crosspoint transistors under control of a single control signal, irrespective the state of the inputs and the product lines, in that way disabling current leakage through crosspoint transistors, which would otherwise conceal current leakage through bridging defects.

According to an embodiment of the invention, the integrated circuit is characterized in that the precharge lines are connected to respective precharge transistors and that the evaluate lines are connected to respective evaluate transistors, the arrangement being such that adjacent first row lines and adjacent second column lines switch to complementary logic levels. This expresses the understanding that for each pair of lines consisting of a precharge line and a corresponding evaluate line, one has the freedom to choose to precharge to either one of the possible logic levels (and to evaluate to the complementary logic level). By applying this understanding when choosing the precharge level and evaluate level for a particular pair, no matter what the layout of precharge lines and evaluate lines is, it is always possible to have an arrangement in which adjacent lines switch to complementary logic levels. In PLAs in which precharge lines and evaluate line alternate, that constraint is automatically met when precharge is done to a first level and evaluate to a second. Often, however, the product lines and sum lines are rearranged with respect to the evaluate lines in order to optimize for IC area. Then, according to the invention, said understanding can be applied in order to arrive at an IDDQ testable dynamic PLA.

According to another embodiment of the invention, the integrated circuit is characterized in that the precharge lines are connected to respective precharge transistors switching the precharge lines in a normal mode to a first level, and the evaluate lines are connected to respective evaluate transistors switching the evaluate lines in the normal mode to a second level, complementary to the first level; pairs of corresponding precharge transistors and evaluate transistors being arranged for inverting said levels under control of a second test control line, said pairs being chosen such that in the test mode adjacent first row lines and adjacent second column lines switch to complementary logic levels. Though such a circuit is IDDQ testable, in the normal mode it uses a preferred logic level for a particular line. It could, for example, be unacceptable that NMOS crosspoint transistors in the normal mode switch precharge lines to logic high because of threshold voltage drop. In that case, these crosspoint transistors switch the corresponding precharge lines to logic low in the normal mode and to logic high in the test mode. The same applies to the evaluate lines.

According to an aspect of the invention, the integrated circuit is characterized in that the circuit is arranged for during the test mode keeping the precharge transistors and the evaluate transistors in an on state simultaneously. This allows all possible pairs of adjacent first row lines and second column lines to be tested for bridging defects simultaneously. Therefore, such a circuit can be tested in very little time.

According to an aspect of the invention, the integrated circuit is characterized in that the circuit is arranged for during the test mode keeping the precharge transistors in an off state and the evaluate transistors in an on state simultaneously. In this way, crosspoint transistors in an on state will not leak current. Thus, by driving adjacent bit lines or adjacent product term lines to complementary logic levels, bridging defects between adjacent bit lines and adjacent product term lines can be detected by IDDQ testing. Of course, the same can be accomplished with a circuit that is arranged the other way around, i.e. in which the precharge transistors and the evaluate transistors simultaneously can be kept in an on state and an off state, respectively.

The invention is further explained below by way of example with reference to the accompanying drawing, in which like reference numerals denote the same or corresponding parts.
Figure 1 is a schematic of a typical known dynamic PLA with some representative bridging defects,
Figure 2 is a schematic of an IDDQ testable dynamic PLA according to a first embodiment of the invention,
Figure 3 is a schematic of an IDDQ testable dynamic PLA according to a second embodiment of the invention.

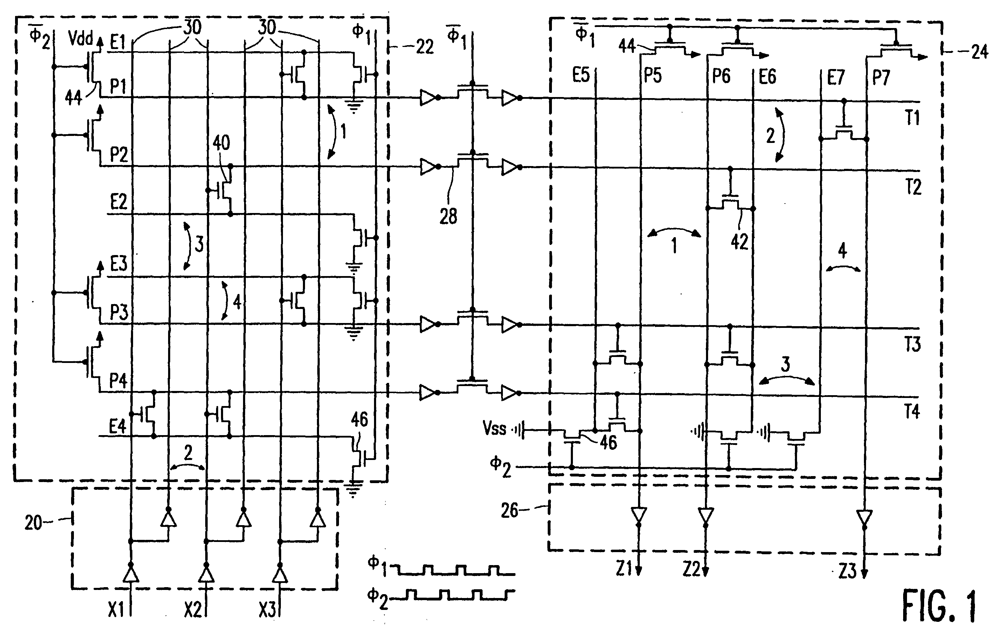

Figure 1 is a schematic of a typical known dynamic PLA with some representative bridging defects. It comprises an input decoder 20, an AND plane 22, an OR plane 24 and output buffering 26. The device has 3 inputs X1-X3, 4 product lines P1-P4, and 3 outputs Z1-Z3.

The distinctive feature of a dynamic PLA is the presence of precharge and evaluate lines in AND plane and OR plane. The precharge lines of the AND plane 22 are the product lines P1-P4. The AND plane 22 further comprises six bit lines 30 derived from the inputs X1-X3 by the input decoder 20, first evaluate lines E1-E4, paired to the product lines P1-P4, respectively, and first crosspoint transistors 40. Respective gates of the first crosspoint transistors 40 are connected to the bit lines and respective sources and drains are connected to pairs of the product lines P1-P4 and the corresponding first evaluate lines E1-E4. Product terms of a function to be programmed in the PLA are realized according to whether or not first crosspoint transistors 40 are inserted at particular locations in the AND plane 22. In the figure, only one of the six first crosspoint transistors 40 in the AND plane 22 is provided with a reference numeral in order to maintain clarity of the circuit.

The precharge lines of the OR plane 24 are sum lines P5-P7. The OR plane 24 further comprises four product term lines T1-T4 coupled to the four product lines P1-P4 via dynamic latches 28, each one of which comprising two inverting buffers and a transistor, second evaluate lines E5-E7, paired to the sum lines P5-P7, respectively, and second crosspoint transistors 42. Respective gates of the second crosspoint transistors 42 are connected to the product term lines and respective sources and drains are connected to pairs of the sum lines P5-P7 and the corresponding second evaluate lines E5-E7. Sum terms of a function to be programmed in the PLA are realized according to whether or not second crosspoint transistors 42 are inserted at particular locations in the OR plane 24. In the figure, only one of the four dynamic latches 28 is provided with a reference numeral in order to maintain clarity of the circuit.

A two phase non-overlapping clock scheme is generally used. During a ϕ₁ phase the AND plane 22 is evaluated and the OR plane 24 is precharged. The first crosspoint transistors 40 enable the product lines P1-P4 to be conditionally discharged, depending on the state of the inputs X1-X3. During a ϕ₂ phase, the OR plane 24 is evaluated and the AND plane 22 is precharged. The second crosspoint transistors 42 enable the sum lines P5-P7 to be conditionally discharged, depending on the state of the product term lines T1-T4. The dynamic latches 28 are placed between the AND plane 22 and the OR plane 24 to buffer the AND plane 22 output.

The precharge and evaluate lines in a dynamic PLA are usually rearranged during layout to make efficient use of the area. Therefore, as indicated in Figure 1, in the AND plane 22 sometimes two product lines are adjacent to each other and sometimes two first evaluate lines are adjacent to each other. Similarly, in the OR plane 24 sometimes sum lines are adjacent to each other and sometimes two second evaluate lines are adjacent to each other.

In a dynamic PLA, there are three classes of devices: the crosspoint transistors 40 and 42, pull-up transistors 44 and pull-down transistors 46. These transistors may have stuck-on behaviour or stuck-open behaviour. Furthermore, a PLA has a large number of interconnections which are susceptible for bridging defects amongst them. In general, there are four basic types of bridging faults possible in AND and OR planes which are illustrated in Figure 1. These bridging faults are: (1) a conductive bridge between two adjacent precharge lines, (2) a conductive bridge between either two adjacent bit lines or two adjacent product term lines, (3) a conductive bridge between two adjacent evaluate lines, (4) a conductive bridge between a precharge line and an adjacent evaluate line.

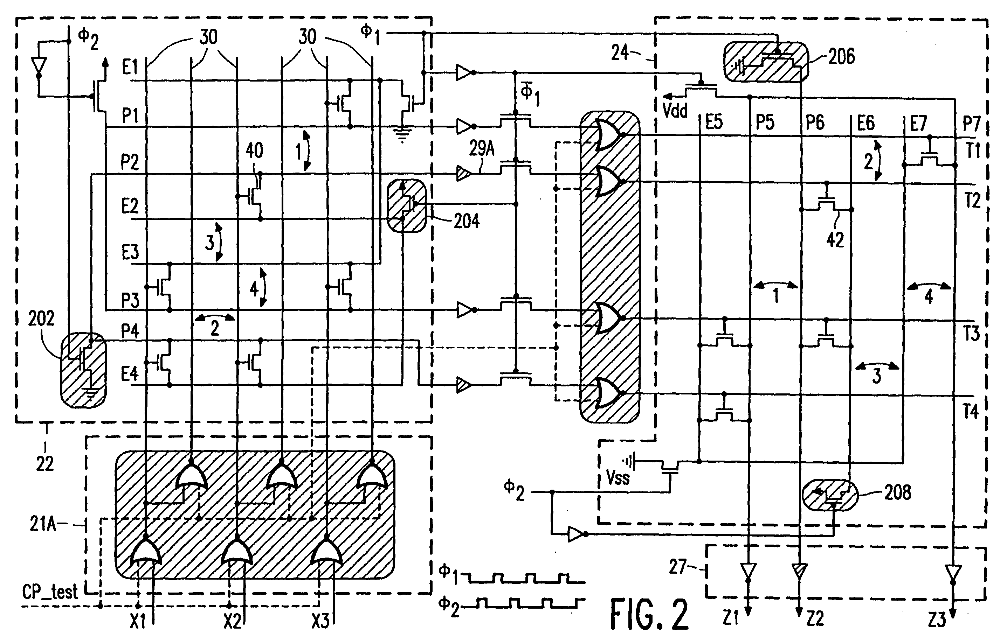

Figure 2 is a schematic of an IDDQ testable dynamic PLA according to a first embodiment of the invention. The circuit of Figure 2 is largely the same as the circuit of Figure 1 except for the highlighted areas. Notably, compared to Figure 1, the circuit of Figure 2 comprises a modified input decoder 21A, modified dynamic latches 29A, each of which comprising a buffer, a transistor and a NOR gate, modified output buffering 27, and modified precharge arrangements 202, 206 and modified evaluate arrangements 204, 208.

In a dynamic PLA, the corresponding precharge lines and evaluate lines should be complementary. For example, if the product lines are precharged to Vdd, then evaluation should be done to Vss (Figure 1) or vice-versa. According to an aspect of the invention, provided that the precharge and evaluation to complementary logic levels constraint is met, one has freedom to choose the Vdd or Vss for individual product or sum lines for precharge (evaluation). This understanding has been exploited in Figure 2. The odd product lines P1 and P3 in the AND plane 22 and the odd sum lines P5 and P7 in the OR plane 24 are precharged to Vdd as before. However, the even product lines P2 and P4 in the AND plane 22 and the even sum line P6 in the OR plane 24 are precharged to Vss (precharge arrangements 202 and 206, respectively). Similarly, the even evaluate lines E2, E4 and E6 are also modified. These lines are evaluated to Vdd (evaluate arrangements 204 and 208). In the dynamic latches 29A and the output buffering 27, the even product lines P2 and P4 and the even sum line P6 are buffered with non-inverting buffers so as to maintain the proper logic operation. A test control line CP_test is provided. CP_test in the normal mode is kept at logic low which ensures the normal PLA operation. At the instance when CP_test is high, the input decoder 21 A pulls down all bitlines in the AND plane 22 and all product term lines in the OR plane 24, ensuring no crosspoint transistor 40, 42 is on.

Let us consider the above mentioned four categories of bridging faults. For a first IDDQ measurement, both the clock phases *ϕ*₁ and ϕ₂ are kept high which will ensure that all the precharge lines P1-P7 and all the evaluate lines E1-E7 in both the planes are active at the same time. Now, depending upon input stimuli conditions, some crosspoint transistors 40, 42 may be on which will invalidate the measurement. Therefore, CP_test is also kept high so that all crosspoint transistors 40, 42 are in off state. Since, all adjacent precharge lines P1-P7 and evaluate lines E1-E7 are driven to complementary logic levels, any bridging fault amongst them will result into elevated quiescent current. Therefore, all type 1,3,4 faults as well as leakage faults in all crosspoint transistors 40, 42 will be detected by this measurement. This test is independent of the function implemented in the PLA. Some extra transistors/gates are needed to facilitate the test. However, compared to the known integrated circuit of Figure 1 the proposed configuration needs very few extra gates. The impact of the extra hardware on performance is insignificant.

A second IDDQ measurement is needed to test for type 2 faults in the AND plane 22. During this measurement, the clock phase ϕ₁ is kept low and the clock phase ϕ₂ is kept high, and the test signal CP_test is kept low. These conditions ensure that no first crosspoint transistor 40 is on in the AND plane 22. Now, the adjacent inputs X1-X3 are driven to complementary logic levels such that all type 2 faults are excited in the AND plane 22 and are detected by elevated quiescent current. This test is also independent of the function implemented in the PLA. Similarly, type 2 faults in the OR plane 24 can also be detected by keeping adjacent product term lines T1-T4 to complementary logic levels. However, realizing it depends on the implemented function. In other words, the test effectiveness is dependent of the implemented function in the AND plane 22. Table 1 shows these three IDDQ measurements for the first embodiment, with test conditions and detected faults by each measurement.

**Table 1.**

| Faults in the second embodiment and their detection conditions. | | | |
|---|---|---|---|
| Test | Test Conditions | Detected Faults | Comments |
| I1 | ϕ₁=1, ϕ₂=1, CP_test=1 | AND plane and OR plane: type 1,3,4 faults, all stuck-on crosspoint faults | function independent test |
| I2 | ϕ₁=0, ϕ₂=1, CP_test=0 | AND plane: type 2 faults | function independent test |
| I3 | ϕ₁=1, ϕ₂=0, CP_test=0 | OR plane: type 2 faults | function dependent test |

In this embodiment, the even precharge lines P2, P4, P6 are evaluated to logic high through the NMOS crosspoint transistors 40, 42. Such a scheme will result in the evaluation to Vdd - Vtp voltage on the even precharge lines P2, P4, P6, in which Vtp designates the threshold voltage drop, characterizing the NMOS transistors. Therefore, care should be taken in the design of the subsequent latches 29A and the output buffering 27, such that they take into account the threshold voltage drop for these lines. The threshold voltage drop on the even precharge lines P2, P4, P6 may be an issue for robust design. It may also result in dc power dissipation in the dynamic latches 29A and the output buffering 27, which will result in increased power consumption. Finally, in low voltage applications, it may result in unacceptably reduced noise margins. There are several possible solutions to solve the problem of threshold voltage drop on the even precharge lines P2, P4, P6. Replacing the NMOS crosspoint transistors 40, 42 with PMOS crosspoint transistors for the even precharge lines P2, P4, P6 is probably the simplest. Such an arrangement will not result in threshold voltage drop. However, it does have other unwanted consequences. For example, testing of type 4 bridging defects will require an elaborate arrangement since forcing logic zero will not switch off PMOS crosspoint transistors. Furthermore, there will be constraints on logic implementation in the AND plane 22 and the OR plane 24. Application of latches or sense amplifiers instead of inverters (buffers) to restore the logic level is yet another solution. However, it may increase the complexity of the PLA and reduce performance without really adding a significant benefit.

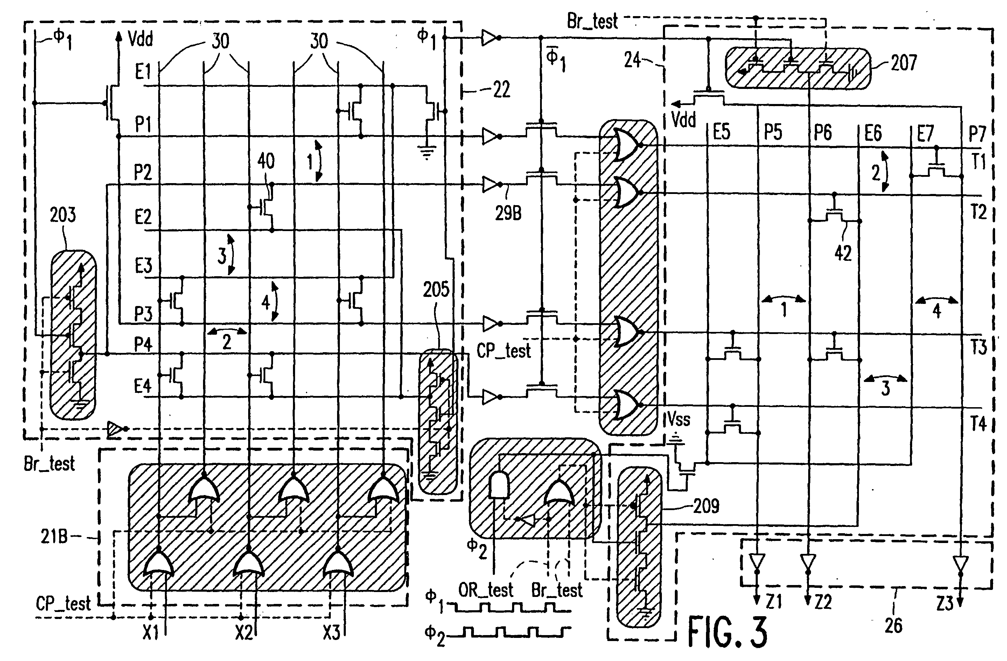

Figure 3 is a schematic of an IDDQ testable dynamic PLA according to a second embodiment of the invention. The circuit of Figure 3 is largely the same as the circuit of Figure 1 except for the highlighted areas. Notably, compared to Figure 1, the circuit of Figure 3 comprises a modified input decoder 21B, modified dynamic latches 29B, each of which comprising an inverting buffer, a transistor and a NOR gate, and modified precharge arrangements 203, 207 and modified evaluate arrangements 205, 209.

It illustrates a modified version of the first embodiment which retains the fault coverage of the previous scheme, alleviates the problem of the threshold voltage drop, and does not result in excessive area and performance penalties. However, this scheme requires two additional test control signals. A second test control line Br_test is provided to control the even precharge lines P2, P4, P6 and the even evaluate lines E1, E2, E6 in the test mode. Similarly, a third test control line OR_test is provided to control the evaluate lines E5-E7 in the OR plane 24 in the test mode. In the normal mode, Br_test as well as OR_test are kept at logic low and the PLA functions as usual, i.e. the product lines P1-P4 and the sum lines P5-P7 are precharged to logic high and evaluated to logic low. However, under test conditions these lines are driven logic high to excite different types of faults. These conditions will be explained in the subsequent paragraphs.

Detection of bridging faults in this PLA is similar to the previous one. For detection of type 1, 3, and 4 bridging faults in both planes the following conditions are required. CP_test is kept at logic high so that all the crosspoint transistors 40, 42 in the PLA are in non-conduction state. The clock phase ϕ₁ is kept high which drives logic low on the odd first evaluate lines E1, E3 and the odd precharge lines P5, P7. The clock phase ϕ₂ is also kept high which enables the odd product lines P1, P3 to be logic high. Furthermore, Br_test is kept at logic high and OR_test is kept at logic low which enables the odd evaluate lines E5, E7 to be driven logic high, the even precharge lines P2, P4, P6 to be driven logic low and the even evaluate lines E2, E4, E6 to be driven logic high. Under these conditions, any bridging fault of above mentioned categories in both planes as well as leakage faults in all the crosspoint transistors 40, 42 will be detected by this measurement. This measurement is independent of the function implemented in the PLA.

Detection of type 2 bridging faults in the AND plane 22 requires an additional IDDQ measurement. In this measurement, the clock phase ϕ₁ is kept at logic high and the clock phase ϕ₂ is kept at logic low. Furthermore, all the test control lines (CP_test, Br_test, and OR_test) are also kept at logic low. These conditions ensure that no crosspoint transistor 40 is on in the AND plane 22. Now, the adjacent inputs X1-X3 are driven to complementary logic levels such that all type 2 bridging faults between the bit lines 30 are excited and can be detected by elevated quiescent current. Like the first measurement, this measurement is independent of the function implemented in the PLA.

For detecting type 2 faults in the OR plane 24 independently of the implemented function, the following scheme is applied. The clock phase ϕ₂ is kept high which enables the odd product term lines T1, T3 to be logic high. Br_test is also kept high which ensures that the even product term lines T2, T4 are driven logic low. Now, the clock phase ϕ₁ is kept high and CP_test is kept low. Such an arrangement ensures that the adjacent product term lines T1-T4 in the OR plane 24 are driven to complementary logic levels. Unfortunately, keeping both clock phases high excites the sum lines P5-P7 and the evaluate lines E5-E7 to complementary logic levels which may cause leakage through the second crosspoint transistors 42 depending upon the logic state of the product lines P1-P4. Therefore, to avoid invalidation of the test, the third test control signal OR_test is provided to control the evaluate lines E5-E7 in the high impedance state. The OR_test signal, which is normally is kept at logic low, is kept at logic high for this test. Under these conditions a type 2 bridging fault between adjacent product term lines T1-T4 will give rise to elevated IDDQ level. Table 2 shows these three IDDQ measurements for the second embodiment, with test conditions and detected faults by each measurement.

With respect to both the first and the second embodiment of the invention as described in the previous paragraphs, it is worthwhile to note that there may be situations where it is not possible to have many extra inputs for test purposes. In such cases, an onboard state machine can be designed with only one or two inputs whose outputs may be decoded to derive these signals. Alternatively, CP_test may be decoded from both the clock phases. As it is clear from Tables 1 and 2, a high CP_test is needed only when both clock phases are high. Therefore, this signal may be derived from clock phases.

**Table 2.**

| Faults in the second embedment and their detection conditions. | | | |
|---|---|---|---|
| Test | Test Conditions | Detected Faults | Comments |
| I1 | ϕ₁=1, ϕ₂=1, CP_test=1, Br_test=1, OR_test=0 | AND plane and OR plane: type 1, 3, 4 faults, all stuck-on crosspoint faults | function independent test |
| I2 | ϕ₁=1, ϕ₂=0, CP_test=0, Br_test=0, OR_test=0, inputs with compl. data | AND plane: type 2 faults | function independent test |
| I3 | ϕ₁=1, ϕ₂=1, CP_test=0, Br_test=1, OR_test=1 | OR plane: type 2 faults | function independent test |

## Claims

1. An integrated circuit comprising a dynamic CMOS Programmable Logic Array with an AND plane (22) and an OR plane (24), the AND plane comprising a first matrix of first row lines and first column lines, the first column lines comprising 2n bit lines (30) derived from *n* inputs, and the first row lines comprising *m* product lines (P1-P4), each product line being accompanied with a corresponding adjacent first evaluate line (E1-E4), the bit lines controlling first crosspoint transistors (40) connecting product lines to corresponding first evaluate lines, the OR plane comprising a second matrix of second row lines and second column lines, the second row lines comprising m product term lines (T1-T4) and the second column lines comprising k sum lines (P5-P7) feeding k outputs, each sum line being accompanied with a corresponding adjacent second evaluate line (E5-E7), the product term lines controlling second crosspoint transistors (42) connecting sum lines to corresponding second evaluate lines, each product term line corresponding to a respective product line, the product lines and the sum lines forming a set of precharge lines,
**characterized in that** the circuit is arranged for during a test mode simultaneously driving lines of pairs of adjacent first row lines and/or second column lines to complementary logic levels and keeping the crosspoint transistors connected to said pairs in an off state, whereby a bridging defect between lines of said pairs gives rise to an elevated power supply current that can be monitored by a built-in current sensor or by an off-chip current sensor connected to the integrated circuit during the test mode to reveal the presence of the bridging defect.

2. An integrated circuit according to Claim 1, **characterized in that** the bit lines (30) and the product term lines (T1-T4) are connected to respective outputs of logic gates (2 1 A, 29A), an input of each logic gate being connected to a first test control line (CP_test), the arrangement being such that the logic gates enable driving the bit lines and product term lines to a switch off level of the crosspoint transistors (40, 42) connected thereto, under control of the first test control line.

3. An integrated circuit according to Claim 2, **characterized in that** the precharge (P1-P7) lines are connected to respective precharge transistors (202, 206) and that the evaluate lines (E1-E7) are connected to respective evaluate transistors (204, 208), the arrangement being such that adjacent first row lines and adjacent second column lines switch to complementary logic levels.

4. An integrated circuit according to Claim 2, **characterized in that** the precharge lines (P1-P7) are connected to respective precharge transistors (203, 207) for switching the precharge lines in a normal mode to a first level, and the evaluate lines (E1-E7) are connected to respective evaluate transistors (205, 209) for switching the evaluate lines in the normal mode to a second level, complementary to the first level, pairs of corresponding precharge transistors and evaluate transistors being arranged for inverting said levels under control of a second test control line (Br_test), said pairs being chosen such that in the test mode adjacent first row lines and adjacent second column lines switch to complementary logic levels.

5. An integrated circuit according to Claim 3 or 4, **characterized in that** the circuit is arranged for during the test mode keeping the precharge transistors and the evaluate transistors in an on state simultaneously.

6. An integrated circuit according to Claim 3 or 4, **characterized in that** the circuit is arranged for during the test mode keeping the precharge transistors in an off state and the evaluate transistors in an on state simultaneously.

7. A method for testing an integrated circuit comprising a dynamic CMOS Programmable Logic Array with an AND plane and an OR plane, **characterized in that** the method comprises the steps of
driving lines of pairs of adjacent row lines in the AND plane and pairs of adjacent column lines in the OR plane to complementary logic levels while simultaneously keeping crosspoint transistors feeding said lines in an off state and measuring a quiescent power supply current; and
driving lines of pairs of adjacent column lines in the AND plane and pairs of adjacent row lines in the OR plane to complementary logic levels while measuring a quiescent power supply current.

## Patentansprüche

1. Integrierte Schaltung mit einer dynamischen CMOS programmierbaren Logikanordnung mit einer UND-Ebene (22) und einer ODER-Ebene (24), wobei die UND-Ebene eine erste Matrix aus ersten Reihenleitungen und ersten Spaltenleitungen aufweist, wobei die ersten Spaltenleitungen 2m Bitleitungen (30) aufweisen, hergeleitet von n Eingängen, und wobei die ersten Reihenleitungen m Produktleitungen (P1-P4) haben, wobei jede Produktleitung von einer entsprechenden benachbarten ersten Bewertungsleitung (E1-E4) begleitet wird, wobei die Bitleitungen erste Kreuzpunkttransistoren (40) steuern, die Produktleitungen mit entsprechenden ersten Bewertungsleitungen verbinden, wobei die ODER-Ebene eine zweite Matrix von zweiten Reihenleitungen und zweiten Spaltenleitungen aufweist, wobei die zweiten Reihenleitungen m Produkttermleitungen (T1-T4) aufweisen und die zweiten Spaltenleitungen k Summenleitungen (P5-P7) aufweisen, die k Ausgänge speisen, wobei jede Summenleitung von einer entsprechenden benachbarten zweiten Bewertungsleitung (E5-E7) begleitet wird, wobei die Produkttermleitungen zweite Kreuzpunkttransistoren (42) steuern, die Summenleitungen mit entsprechenden zweiten Bewertungsleitungen verbinden, wobei jede Produkttermleitung einer betreffenden Produktleitung entspricht, wobei die Produktleitungen und die Summenleitungen einen Satz von Vorladungsleitungen bilden,
**dadurch gekennzeichnet, dass** die Schaltungsanordnung vorgesehen ist, während einer Testmode gleichzeitig Leitungen von Paaren benachbarter erster Reihenleitungen und/oder zweiter Spaltenleitungen gleichzeitig zu komplementären logischen Pegeln zu treiben und dafür zu sorgen, dass die Kreuzpunkttransistoren nach wie vor mit den genannten Paaren in einem AUS-Zustand verbunden sind, wobei ein Überbrückungsdefekt zwischen Leitungen der genannten Paare einen erhöhten Speisestrom veranlasst, der durch einen eingebauten Stromsensor oder durch einen mit der integrierten Schaltung verbundenen Off-Chip-Sensor während der Testmode überwacht werden kann, und zwar um das Vorhandensein des Überbrückungsdefektes zu zeigen.

2. Integrierte Schaltung nach Anspruch 1, **dadurch gekennzeichnet, dass** die Bitleitungen (30) und die Produkttermleitungen (T1-T4) mit betreffenden Ausgängen logischer Gatter (21A, 29A) verbunden sind, wobei ein Eingang des logischen Gatters mit einer ersten Teststeuerleitung (CP_test) verbunden ist, wobei die Anordnung derart ist, dass die logischen Gatter die Bitleitungen und die Produkttermleitungen zu einem Abschaltpegel der damit verbundenen Kreuzpunkttransistoren (40, 42) treiben können, und zwar unter Ansteuerung der ersten Teststeuerleitung.

3. Integrierte Schaltung nach Anspruch 2, **dadurch gekennzeichnet, dass** die Vorladungsleitungen (P1-P7) mit entsprechenden Vorladungstransistoren (202, 206) verbunden sind und dass die Bewertungsleitungen 9E1-E7) mit betreffenden Bewertungstransistoren (204, 208) verbunden sind, wobei die Anordnung derart ist, dass benachbarte erste Reihenleitungen und benachbarte zweite Spaltenleitungen zu komplementären logischen Pegeln umschalten.

4. Integrierte Schaltung nach Anspruch 2, **dadurch gekennzeichnet, dass** die Vorladungsleitungen (P1-P7) mit betreffenden Vorladungstransistoren (203, 207) zum Umschalten der Vorladeleitungen in einer normalen Mode auf einen ersten Pegel verbunden sind, und die Bewertungsleitungen (E1-E7) mit betreffenden Bewertungstransistoren (205, 209) zum Umschalten der Bewertungsleitungen in der normalen Mode auf einen zweiten Pegel verbunden sind, wobei zusätzlich zu dem ersten Pegel Paare entsprechender Vorladungstransistoren und Bewertungstransistoren dazu vorgesehen sind, unter Ansteuerung einer zweiten Teststeuerleitung (Br_test) die genannten Pegel zu invertieren, wobei die genannten Paare derart gewählt werden, dass in der Testmode angrenzende erste Reihenleitungen und benachbarte zweite Spaltenleitungen auf komplementäre logische Pegel umschalten.

5. Integrierte Schaltung nach Anspruch 3 oder 4, **dadurch gekennzeichnet, dass** die Schaltungsanordnung dazu vorgesehen ist, während der Testmode die Vorladungstransistoren und die Bewertungstransistoren gleichzeitig in einem EIN-Zustand zu halten.

6. Integrierte Schaltung nach Anspruch 3 oder 4, **dadurch gekennzeichnet, dass** die Schaltungsanordnung dazu vorgesehen ist, während der Testmode die Vorladungstransistoren in einem AUS-Zustand zu halten und die Bewertungstransistoren gleichzeitig in einem EIN-Zustand zu halten.

7. Verfahren zum Testen einer integrierten Schaltung mit einer dynamischen CMOS programmierbaren logischen Anordnung mit einer UND-Ebene und einer ODER-Ebene, **dadurch gekennzeichnet, dass** das Verfahren die nachfolgenden Verfahrensschritte umfasst:
- das Treiben von Leitungen von Paaren benachbarter Reihenleitungen in der UND-Ebene und Paaren benachbarter Spaltenleitungen in der ODER-Ebene zu komplementären logischen Pegeln, während gleichzeitig Kreuzpunkttransistoren, welche die genannten Leitungen speisen, in einem AUS-Zustand gehalten werden und ein ruhender Speisestrom gemessen wird; und
- das Treiben von Leitungen von Paaren benachbarter Spaltenleitungen in einer UND-Ebene und Paaren benachbarter Reihenleitungen in der ODER-Ebene zu komplementären logischen Pegeln, während ein ruhender Speisestrom gemessen wird.

## Revendications

1. Circuit intégré comprenant un Réseau Logique Programmable CMOS dynamique avec un plan ET (22) et un plan OU (24), le plan ET comprenant une première matrice de premiers conducteurs de lignes et de premiers conducteurs de colonnes, les premiers conducteurs de colonnes comprenant 2*n* conducteurs de bits (30) dérivés de n entrées, et les premiers conducteurs de lignes comprenant *m* conducteurs de produit (P1-P4), chaque conducteur de produit étant accompagné d'un premier conducteur d'évaluation adjacent correspondant (E1-E4), les conducteurs de bits commandant des premiers transistors de points d'intersection (40) connectant des conducteurs de produit à des premiers conducteurs d'évaluation correspondants, le plan OU comprenant une seconde matrice de seconds conducteurs de lignes et de seconds conducteurs de colonnes, les seconds conducteurs de lignes comprenant *m* conducteurs de termes de produit (T1-T4) et les seconds conducteurs de colonnes comprenant *k* conducteurs de somme (P5-P7) alimentant *k* sorties, chaque conducteur de somme étant accompagné d'un second conducteur d'évaluation adjacent correspondant (E5-E7), les conducteurs de termes de produit commandant des seconds transistors de points d'intersection (42) connectant les conducteurs de somme à des seconds conducteurs d'évaluation correspondants, chaque conducteur de terme de produit correspondant à un conducteur de produit respectif, les conducteurs de produit et les conducteurs de somme formant un ensemble de conducteurs de précharge,
**caractérisé en ce que** le circuit est conçu pour faire passer simultanément, pendant un mode de test, des conducteurs de paires de premiers conducteurs de lignes et/ou de seconds conducteurs de colonnes adjacents à des niveaux logiques complémentaires et pour maintenir les transistors de plans d'intersection connectés auxdites paires dans un état non passant, d'où il résulte qu'un défaut de pontage entre des conducteurs desdites paires donnent lieu à un courant d'alimentation électrique élevé qui peut être surveillé par un capteur de courant intégré ou par un capteur de courant extérieur à la puce connecté au circuit intégré pendant le mode de test pour révéler la présence du défaut de pontage.

2. Circuit intégré selon la revendication 1, **caractérisé en ce que** les conducteurs de bits (30) et les conducteurs de termes de produit (T1-T4) sont connectés à des sorties respectives de portes logiques (21A-29A), une entrée de chaque porte logique étant connectée à un premier conducteur de commande de test (CP_test), la configuration étant telle que les portes logiques permettent le passage des conducteurs de bits et des conducteurs de termes de produit à un niveau non passant des transistors de points d'intersection (40, 42) qui leur sont connectés, sous le contrôle du premier conducteur de commande de test.

3. Circuit intégré selon la revendication 2, **caractérisé en ce que** les conducteurs de précharge (P1-P7) sont connectés à des transistors de précharge respectifs (202, 206) et **en ce que** les conducteurs d'évaluation (E1-E7) sont connectés à des transistors d'évaluation respectifs (204, 208), la configuration étant telle que les premiers conducteurs de lignes adjacents et que les seconds conducteurs de colonnes adjacents passent à des niveaux logiques complémentaires.

4. Circuit intégré selon la revendication 2, **caractérisé en ce que** les conducteurs de précharge (P1-P7) sont connectés à des transistors de précharge respectifs (203, 207) pour faire passer les conducteurs de précharge à un premier niveau dans un mode normal, et les conducteurs d'évaluation (E1-E7) sont connectés à des transistors d'évaluation respectifs (205, 209) pour faire passer, dans le mode normal, à un second niveau complémentaire du premier niveau, des paires de transistors de précharge et de transistors d'évaluation correspondants étant configurées de façon à inverser lesdits niveaux sous le contrôle d'un second conducteur de commande de test (Br_test), lesdites paires étant choisies de façon à ce que, dans le mode de test, des premiers conducteurs de lignes adjacents et des seconds conducteurs de colonnes adjacents passent à des niveaux logiques complémentaires.

5. Circuit intégré selon la revendication 3 ou 4, **caractérisé en ce que** le circuit est conçu pour maintenir simultanément, pendant le mode de test, les transistors de précharge et les transistors d'évaluation dans un état passant.

6. Circuit intégré selon la revendication 3 ou 4, **caractérisé en ce que** le circuit est conçu pour maintenir simultanément, pendant le mode de test, les transistors de précharge dans un état non passant et les transistors d'évaluation dans un état passant.

7. Procédé pour tester un circuit intégré comprenant un Réseau Logique Programmable CMOS dynamique ayant un plan ET et un plan OU, **caractérisé en ce que** le procédé comprend les étapes suivantes :
passage de conducteurs de paires de conducteurs de lignes adjacents dans le plan ET et de paires de conducteurs de colonnes adjacents dans le plan OU à des niveaux logiques complémentaires tout en maintenant simultanément des transistors de point d'intersection alimentant lesdits conducteurs dans un état non passant et en mesurant un courant d'alimentation électrique de repos ; et
passage de conducteurs de paires de conducteurs de colonnes adjacents dans le plan ET et de paires de conducteurs de lignes adjacents dans le plan OU à des niveaux logiques complémentaires tout en mesurant un courant d'alimentation électrique de repos.
